# EUROPEAN PATENT APPLICATION

(11) **EP 3 379 584 A1**
(43) Date of publication of application: **26.09.2018**
(21) Application number: 17161813.5
(22) Date of filing: 20.03.2017
(51) Int. Cl.: H01L 31/0236, H01L 31/18, B82Y 40/00

(54) **METHOD FOR PRODUCING IMPROVED BLACK SILICON ON A SILICON SUBSTRATE**

(71) Applicant: Université catholique de Louvain, 1348 Louvain-la-Neuve (BE)
(72) Inventor: FRANCIS, Laurent, 1390 Grez-Doiceau (BE); PONCELET, Olivier, 5000 Namur (BE); FLANDRE, Denis, 1170 Bruxelles (BE); KOTIPALLI, Raja Venkata Ratan, 1348 Louvain-la-Neuve (BE); CRAHAY, André, 4280 Hannut (BE)
(74) Representative: Gevers Patents

(57) **Abstract**

Method for producing an optoelectronic material comprising improved black silicon (1) on a silicon substrate (7) and comprising:
- providing a nano-mask (11) comprising a plurality of nanoparticles having a composition different from the one of said silicon substrate (7) and having a surface density on a top surface (12) comprised between 25 and 500 nanoparticles per µm²;
- etching the silicon substrate (7) top surface (12) for forming black silicon (1) comprising a plurality of silicon nano-cones (2) having a height comprised between 300 nm and 3000 nm, and a width comprised between 50 and 200 nm;
- growing a silicon oxide layer on black silicon (1) to form a surface layer (4);
- removing said surface layer (4) having a thickness up to 50 nm;
- depositing a passivation layer (5) on said plurality of silicon nano-cones (2).

## Description

### Technical area

According to a first aspect, the invention relates to a method for producing improved black silicon on a silicon substrate.

According to a second aspect, the invention relates to an optoelectronic material obtained by the method according to the first aspect of the invention.

According to a third aspect, the invention relates to an optoelectronic material.

### Prior art

Materials for optoelectronic applications and especially for the conversion of light into an electrical signal need to combine two main parameters such as to be able to harvest a maximum number of photons out of an incident light and to provide a sufficient lifetime for minority charge carriers. Silicon being the most common material for optoelectronic applications, there has been substantial development for improving silicon performances such as modifying the silicon surface in order to improve its absorption spectrum.

Black silicon is a silicon surface nanostructure of silicon having a needle shaped surface structure with the needles being made of silicon. Black silicon needles have a density, dimensions and a gradient of refractive indexes that allow to improve the absorption compared to a polished silicon substrate.

The scientific publication "An 18.2%-efficient black-silicon solar cell achieved through control of carrier recombination in nanostructures, J. Oh et al., Nature Nanotechnology 7, 743-748 (30 september 2012)" describes a process for obtaining a black silicon surface on a silicon substrate. The process for obtaining silicon nanostructures is a two-step metal-assisted etching technique. A first etching step is achieving after that metallic nanoparticles have been randomly dispersed over a silicon substrate. The first etching step allows for etching the silicon substrate under the metallic nanoparticles and for the creation of a nanoporous silicon structure. A second etching step is applied for etching the metallic nanoparticles. A third wet etching step is then performed after removal of the metallic nano particles in order to remove excess silicon and to leave out silicon needles. The duration of the second etching step is said to be a good way to tune the surface area and thus the height and width of the black silicon needles.

This document further describes important design rules for black silicon in order to improve its internal quantum efficiency (IQE) in the 400 to 600 nm range mainly. This document teaches that the high aspect ratio of the black silicon is important to enhance the photon absorption especially in the 400 to 600 nm range but also recites that the doping concentration of the black silicon surface is even more important for controlling the photogenerated charge-carrier recombination process. This document shows that for analogous black silicon structures, the absorption in the 400 to 600 nm range can be significantly improved by managing the doping concentration in the black silicon region of a silicon substrate.

The scientific publication "Black silicon solar cells with interdigitated back-contacts achieve 22.1% efficiency, H. Savin, et al., Nature Nanotechnology, 10, 624-628 (18 may 2015)" describes black silicon passivated by atomic layer deposition (ALD) of aluminium oxide (Al₂O₃). Al₂O₃ passivation layer shows good antireflective properties in order for the black silicon utilized for solar cells to absorb more photons. Furthermore, an Al₂O₃ passivation layer is said to address the surface recombination problem present at black silicon nanostructured surfaces. The surface recombination problem of photo generated charge carriers is said to directly impact the minority carrier lifetime. The minority carrier lifetime being the limiting parameter in photovoltaic devices. The surface recombination problem in black silicon is said to originate from the processing conditions. During etching, dangling bonds and etching defects are created at the black silicon surface. This document recites that the minority carrier lifetime is increased by applying a passivation layer of Al₂O₃. By extension it can be said that the minority carrier lifetime is a good parameter to assess the quality of a material and in the present case of a nanostructured material. The minority carrier lifetime is also said to be a good indicator about how well the surfaces are passivated.

Although obtaining a surface of black silicon on a conventional silicon wafer by the fabrication of silicon needles is known, obtaining interesting and reproducible optoelectronic devices such as photovoltaic and photodetector devices is still of a challenge. The advantage of black silicon is that it is a better light absorbing material than polished silicon, or even micro-texturized silicon, especially in the blue region of the visible spectrum and in the near infrared region. The advantage of black silicon is that it harvests light on a wide wavelength-range in a better way than polished silicon. However the drawback of black silicon to compete with silicon in optoelectronic applications is that the absorbed photons are poorly converted into electrons at the electrodes due to surface recombination problems because of low minority carrier lifetime. In other words, this results in low minority carrier lifetime due to high surface recombination rates.

The main drawback of black silicon described in the literature is that either the black silicon has a microstructure or nanostructure showing very good absorption characteristic but poor minority carrier lifetime. Either the black silicon has a relatively good minority carrier lifetime but not an optimized microstructure or nanostructure for an optimized light absorption.

### Summary of the invention

According to a first aspect, one of the objects of the present invention is to provide a method for the fabrication of improved black silicon. To this end, the inventors suggest a method for producing improved black silicon on a silicon substrate and comprising the following steps :
a. providing a silicon substrate comprising a top surface;
b. providing a nano-mask on said top surface, said nano-mask comprising a plurality of nanoparticles, said nanoparticles having a composition different from the one of said silicon substrate and having a surface density on said top surface comprised between 25 and 500 nanoparticles per µm²;
c. processing said silicon substrate from said top surface covered by said nano-mask for forming black silicon, said black silicon comprising:
   - a plurality of silicon nano-cones with a density comprised between 25 and 500 nano-cones per µm², each of said silicon nano-cones having a nano-cone base and a nano-cone tip;
   - each of said silicon nano-cones having a nano-cone height delimited by said nano-cone base and said nano-cone tip;
   - said nano-cone base being parallel to said top surface of said silicon substrate and being delimited along one direction by a first base end and a second base end;
   - each of said silicon nano-cones having a nano-cone width delimited by said first base end and by said second base end;
   - said nano-cone height being comprised between 300 nm and 3000 nm, and;
   - said nano-cone width being comprised between 50 and 200 nm;
d. removing a surface layer of each of said silicon nano-cones, said surface layer having a thickness up to 50 nm;
e. depositing a passivation layer on said plurality of silicon nano-cones after previous step.

The method of the invention provides a way to produce improved black silicon having both good optical properties and good electrical properties. The improved black silicon produced by the method of the invention is a good compromise between optical properties and electrical properties. Good optical properties for black silicon are an absorption spectrum showing an absorbance close to 1 over a large range of wavelengths. Good optical properties for black silicon are a low reflection spectrum showing a reflectance lower than 1 % over a large range of wavelengths. Good optical properties for black silicon are also a good angular acceptance over a large incidence angle for absorption of light. Good electrical properties for black silicon are a low surface recombination velocity and a long minority lifetime. Good intrinsic electrical properties for black silicon are a low surface recombination velocity and a long minority carrier lifetime.

Nano-cones can also be called needles, nano-needles, pillars, nano-pillars, rods, nano-grass, nano-wiskers...

The method of the invention provides a way to give to the surface of a silicon substrate a nanostructure formed with nano-cones. The shape of said nano-cones is essential for getting a black silicon material exhibiting optimal optical and electrical properties. Nano-cones are called as such because they mainly have a conical structure or shape, defined by a base that has for example a shape of a circle and by a tip. A cone is preferably found to be the closest regular geometrical shape that can define the obtained nanostructure on a silicon substrate. Said nanostructure is preferably periodic, each of said repeating element preferably being a nano-cone. Said nano-cones preferably have a straight edge from base to tip. Preferably said nano-cones have a sharp shape, that is to say that they have an aspect ratio comprised between 5 and 40, more preferably comprised between 7 and 20 and still more preferably around 10. The aspect ratio is defined by the ratio between the dimension of the height divided by the dimension of the base width or of the diameter of a single or a population of nano-cones. The nanostructure is preferably a nano-cone structure because it shows optimal optical properties than nanostructures having a pillar shape or for example a shape of a cone with the edge between the base and tip being concave.

Nano-cones obtained by the method of the invention are preferred to other shapes in that they allow a good nanostructure density and good black silicon optical properties. The nano-cone structure is a good trade-off for giving to the black silicon good electrical and optical properties. The nano-cone structure is a good trade-off for giving to the black silicon good intrinsic electrical and optical properties. Furthermore the nano-cones allow a homogeneous deposition of the passivation layer thanks to their conic shape. The shape and density of the obtained nano-cones are critical to form optimized black silicon.

The method of the invention allows to produce black silicon having excellent optoelectronic properties because it allows to create silicon nano-cones which have a surface layer on their surface that can be removed by the method without losing on the density and on the shape of the silicon nano-cones. This is possible because after formation of the silicon nano-cones, the surface layer of the nano-cones contains relatively low damage layer thickness and number of defects or dangling bonds compared to other methods. The method of the invention allows to remove said surface layer with keeping the optimal and or required density and shape of the silicon nano-cones at the silicon substrate top surface.

The advantage of the invention is to provide a black silicon surface on a silicon substrate with a black silicon surface having a low defect density. The low defect density is obtained thanks to the combination of a smooth etching process and of the removal of a surface layer at the black silicon surface obtained after its fabrication. Said surface layer being for example a damaged surface layer.

The dimensions of the nano-cone being the nano-cone height and the nano-cone width are preferably average values *A* of a silicon nano-cone population of black silicon. Preferably these dimensions ranges comprise 50% of the population of nano-cones of the black silicon. These dimensions ranges comprise preferably most of the nano-cones of the black silicon. These dimensions ranges preferably comprise, considering a Gaussian distribution of a dimension, more than the interval *comprising A -* σ *and A* + σ of said nano-cone population, σ being the standard deviation of the nano-cone population of black silicon. For example, these dimensions ranges comprise the interval A - 2.σ and *A* + 2.σ of said nano-cone population. For example, these dimensions ranges comprise the interval *A -* 3.σ and *A* + 3.σ of said nano-cone population. For example, these dimensions ranges comprise all the nano-cone population.

Said surface layer on said silicon nano-cones preferably has a maximum thickness of 50 nm, more preferably has a maximum thickness of 25 nm and even more preferably has a maximum thickness of 15 nm. Preferably said surface layer has a minimum thickness of 1 nm, more preferably has a minimum thickness of 3 nm and even more preferably has a minimum thickness of 5 nm.

The method of the invention allows to reduce the defect density at the black silicon surface. Defects of the black silicon surface are surface or interface traps. Defects in the bulk of the black silicon nano-cone are bulk traps. Growing and removing an oxide layer at the surface of the black silicon surface allows to remove a large number or a large density of surface traps.

The method of the invention, by lowering the surface trap density, allows to balance (i.e. electrically inactivate) remaining surface traps and bulk traps by providing a passivation layer. The method of the invention, by lowering the surface trap density, allows electrically inactivate remaining surface traps and bulk traps by providing a surface passivation layer.

In the present method, the advantage of depositing a passivation layer subsequently to the removal of a high surface trap density layer is that the effect of the passivation layer is increased because the number of surface traps has been significantly decreased before. In fact the passivation layer allows to neutralize surface traps and or bulk traps because the passivation layer has a net charge that has an opposite charge to the charge of the defects that are in the surface and or bulk traps. In fact the passivation layer allows to neutralize interface traps but also to create strong built-in field that can repel the minority carriers from being recombined at the surface because the passivation layer has a net charge that has an opposite charge to the charge of the defects that are at the surface, at the interface and or bulk traps. For example, minority carriers are pushed away from the traps due to the field effect coming from the passivation layer. Minority carriers are pushed away because they have the same charge than the passivation layer. Minority carriers are pushed away because they have the same charge than the fixed charges within or at the interface of the passivation layer.

For optimal optical properties, the passivation layer should not be too thick. The thickness of the passivation layer is a trade-off between the optical properties and the electronic properties of the black silicon. For example, a thick passivation layer compared to the optimal passivation layer thickness gives good electronic properties to the material (good minority carrier lifetimes) but bad optical properties (high reflectance). Opposite, a thin passivation layer compared to the optimal passivation layer thickness gives bad electronic properties but good optical properties.

For example, the passivation layer does not need to have negative charges to yield similar effects than described in the previous paragraph: a thick thermally grown SiO2 passivation layer comprised between 30-35 nm should yield minority charge carrier lifetimes above 1.5 ms. Our recent results have shown that a thermally grown SiO2 passivation layer comprised between 2 to 3 nm yields minority charge carrier lifetimes comprised between 600 to 700 µs. Comparatively to this example, passivation layer of aluminium oxide, having negative charges yields minority charge carrier lifetimes of about 3 ms.

The advantages of the invention are as follow as it allows to:
- lower the surface trap density of black silicon;
- passivate the black silicon nano-cones in order to reduce the surface recombination velocity of photo absorbed charge carriers and thus to improve the minority carrier lifetime of black silicon;
- obtain nano-cones with a width or base size in the order of 100 nm, with the nano-cones being close to each other's in order to reach a nano-cone surface density in the order of 100 nano-cones per µm².

The scientific publication "Black silicon solar cells with interdigitated back-contacts achieve 22.1 % efficiency, H. Savin, et al., Nature Nanotechnology, 10, 624-628 (18 may 2015)" claims obtaining a minority carrier lifetime for black silicon of about 0.9 ms. The method of the invention allows to obtain black silicon on a silicon wafer with minority carrier lifetime above 3 ms. The minority carrier lifetime of the black silicon obtained by the method of the invention can have a value of 3800 µs.

The advantage of the method is that it provides etching techniques which induce a limited number of additional defects and a damage removal etch (DRE) step that is more efficient than conventional DRE techniques in term of time and chemical use. The advantage of the invention is that it provides techniques that are highly compatible with the industrial installations and that allow a better throughput than process using conventional black silicon formation and DRE. A throughput increase by a factor 2 to 3 is expected with the method of the invention for obtaining at least a state-of-the-art product.

The silicon nano-cone width can also be referred to as being the interval between the centre of two adjacent nano-cones or as being the interval between two adjacent nano-cone tips. The surface layer is preferably a defective layer. Said surface layer is preferably a defective silicon layer. Said surface comprises for example a defective layer of silicon and a native layer of silicon oxide.

The silicon substrate is preferably monocrystalline. The silicon substrate is for example polycrystalline. The starting silicon substrate is preferably not doped. The silicon substrate is more preferably p-type doped. For example the silicon substrate is n-type doped. Preferably the silicon substrate has a sheet resistance comprised between 1 and 10 ohm.cm (*i*.e. a doping concentration comprised between 10¹⁵ cm⁻³ and 5x10¹⁵ cm⁻³). For example a non-doped silicon substrate is an intrinsic silicon substrate with a sheet resistance higher than 5000 ohm.cm (*i.e.* a doping concentration of about 10¹⁰ cm⁻³).

The method of the invention can adapt to any black silicon because said method allows to mitigate the surface traps that causes surface recombination and that can be characterized electronically by a low minority carrier lifetime.

The advantage of the invention is to use plasma etching or reactive ion etching which is an etching technique which induces a low amount of defects at the surface of the remaining material. The state-of-the-art fabrication of black silicon for example involves etching steps which leaves the black silicon with a black silicon surface having a high defect density. The method of the invention allows to obtain a black silicon with a defective layer being lower to 50 nm and allows the removal of said defective layer without sacrificing optimal nano-cone dimensions and density.

The advantage of using a plasma etching step or a reactive ion etching step is that it requires less manipulation of hazardous chemicals than with a wet chemical etching. The advantage of the plasma etching step is that it is a soft etching that prevents for the formation of a large number of defects at the surface of the etched material.

The advantage of using a nano-mask deposited on the top surface of the silicon substrate is that the nano-mask is supported by the substrate itself and there is no need to provide a mask holder for example. The nano-mask can therefore be made in the nanometer range consisting on dispersed nanoparticles. The nanoparticles that are used as nano-mask are nanoparticles that have a composition different than the composition of the silicon substrate. For example the composition of the nanoparticle is not silicon. If the nanoparticle composition was silicon, the etching process may etch both the substrate and the mask. For example they are made of any other material than silicon. Nano-mask nanoparticles are for example silicon oxide, metallic, aluminium oxide, hafnium oxide, titanium oxide, zinc oxide... They can be made of many types of metals or oxides, nitrides or carbides.

The advantage of the invention is to obtain a high density of nano-cones on the silicon substrate. The density of the nano-cones is high and the repetition rate of the nano-cones at the surface of the silicon substrate is very good. High density is required to procure uniform optoelectronics properties. Preferably all nano-cones bases should be closely packed to each other.

Preferably, the method comprises an additional step between step c. and step d.:
- growing after step c. an oxide layer on said silicon nano-cone to form said surface layer to be removed in step d..

The advantage of growing an oxide layer on said silicon nano-cones is that the surface layer of the silicon nano-cones is modified into silicon oxide and then it is removed. The growth of an oxide layer with a silicon nano-cone surface layer that has defects and traps and the subsequent removal of the just grown oxide layer allow to remove a silicon nano-cone surface layer and to leave out a silicon nano-cone with a lower defect density. The method allows to reduce the silicon nano-cone surface trap density.

The advantage of the invention is to lower the surface trap density of black silicon in order to reduce the surface recombination velocity of photo generated charge carriers and thus to improve the minority carrier lifetime of black silicon.

Preferably, the oxide layer is grown by a thermal oxidation technique.

The advantage of using a thermal oxidation technique to grow an oxide layer is that the oxide layer is grown conform to the black silicon nano-cones surface. The oxide thickness with this technique is uniform over the black silicon nano-cones surface.

Preferably, the surface layer is a defective surface layer. For example the surface layer has a charge density because of defects and traps higher than 1x10¹² charges per cm². For example the surface layer has a charge density because of defects and traps higher than 5x10¹² charges per cm².

Preferably, the nanoparticles are made in a material resistant to plasma etching. The advantage of using a material resistant to plasma etching for the nanoparticles is that the nanoparticles can act as nano-mask during a plasma etching step.

Preferably, the nanoparticles are oxide nanoparticles.

Preferably, the nanoparticles are metal-oxide nanoparticles.

Preferably, step b. comprises the following steps:
- providing a chamber for receiving said silicon substrate;
- providing an oxide coated wafer;
- placing said oxide coated wafer into said chamber;
- etching of said oxide coated wafer with a CCl₄ plasma for forming nanoparticles inside said chamber;
- removing said oxide coated wafer from said chamber;
- placing said silicon substrate into said chamber for depositing oxide nanoparticles on a top surface of said silicon substrate;
and in that step c. comprises the following step:
- c.1. subjecting said silicon substrate to a plasma for etching it from areas of said top surface located around nanoparticles deposited on said silicon substrate top surface.

The advantage to etch an oxide layer prior to place the silicon substrate into the plasma chamber is to provide oxide nanoparticles into the plasma chamber. Nanoparticles deposited at the top surface of the silicon substrate allow a mask-free process. No external mask needs to be provided. The masking nanoparticles are self-supported by the silicon substrate. For example the nanoparticles are deposited onto the walls of the chamber after etching of the oxide coated wafer and released onto the top surface of the silicon substrate.

Preferably, step c. comprises the following additional step:
- subjecting said etched silicon substrate to a chemical composition for removing a top part of it, with a height comprised between 10 nm and 2700 nm.

The advantage of removing a top part of the etched silicon substrate, having for example a sandglass structure, is to remove the excess material which can be for example the nano-mask nanoparticles, some silicon oxide and the top part of the silicon structure in order to obtain silicon nano-cones.

Preferably, in step c.1. said silicon substrate is etched with a depth comprised between 300 nm and 3000 nm.

Preferably, a plasma etching technique with a Cl₂/O₂ plasma is used for step c.1..

The advantage of using a Cl₂/O₂ plasma is that it allows a relatively smooth etching of the silicon substrate in order to get a sandglass structure. For example, the Cl₂/O₂ plasma is particularly compatible with the nano-mask because the oxygen ions allow to react with the nano-mask and the surroundings of the nano-mask to form an oxide and the chloride ions allow to react with the silicon that is not covered by the nano-mask nanoparticles or by a silicon oxide layer.

In combination with the nano-mask, the Cl₂/O₂ plasma preferably allows to etch the areas of the top surface located around the nano-mask nanoparticles deposited on the silicon substrate top surface.

Preferably, the Cl₂/O₂ plasma is formed with a RF-frequency comprised between 150 KHz and 200 KHz.

A plasma formed with a RF-frequency comprised between 150 KHz and 200 KHz and more preferably at a RF-frequency of 187.5 KHz is an important parameter in order to get black silicon with nano-cones and by using the nano-mask described in the text.

Preferably, the passivation layer is an aluminium oxide layer deposited with a chemical vapour deposition technique.

Preferably, the passivation layer (5) is deposited with an atomic layer deposition technique. Preferably, the passivation layer has an oxide charge density comprised between 5 x 10¹¹ cm⁻² and 8 x 10¹² cm⁻².

The advantage of using ALD is that it allows the formation of uniform films over large areas with growth control at the atomic level. Furthermore ALD allows to deposit and passivate deeps between nano-cones, deep trenches or even pores in silicon.

Preferably, the passivation layer is annealed. Preferably, the passivation layer is annealed in a forming gas. Preferably, the forming gas has a composition comprising H₂ and N₂.

Preferably, a method for producing improved black silicon on a silicon substrate and comprises the following steps :
a. providing a silicon substrate comprising a top surface;
b. processing said silicon substrate from said top surface covered by said nano-mask for forming black silicon, said black silicon comprising:
   - a plurality of silicon nano-cones with a density comprised between 25 and 500 nano-cones per µm², each of said silicon nano-cones having a nano-cone base and a nano-cone tip;
   - each of said silicon nano-cones having a nano-cone height delimited by said nano-cone base and said nano-cone tip;
   - said nano-cone base being parallel to said top surface of said silicon substrate and being delimited along one direction by a first base end and a second base end;
   - each of said silicon nano-cones having a nano-cone width delimited by said first base end and by said second base end;
   - said nano-cone height being comprised between 300 nm and 3000 nm, and;
   - said nano-cone width being comprised between 50 and 200 nm;
c. removing a surface layer of each of said silicon nano-cones, said surface layer having a thickness up to 50 nm;
d. depositing a passivation layer on said plurality of silicon nano-cones after previous step.

The inventors also suggest an opto-electronic material comprising:
- a silicon substrate comprising black silicon on top of said silicon substrate obtained by the method of the invention.

The advantages described for the method for producing improved black silicon on a silicon substrate according to the first aspect of the invention also apply to the optoelectronic material according to the second aspect, *mutatis mutandis.* The different variants for the method according to the first aspect of the invention as described in the preceding text also apply to the optoelectronic material according to the invention, *mutatis mutandis.*

The optoelectronic material comprising black silicon on a silicon substrate obtained by the method of the invention is particularly suited for highly efficient photovoltaic devices.

Preferably, the optoelectronic material comprising black silicon on a silicon substrate obtained by the method of the invention is particularly suited for metal-insulator-semiconductor inversion layer (MIS-IL) photovoltaic devices.

The optoelectronic material comprising black silicon on a silicon substrate obtained by the method of the invention is particularly suited for highly efficient photodetector devices because the optoelectronic material enables a low dark current and a low recombination current.

Preferably, the optoelectronic material comprising black silicon on a silicon substrate obtained by the method of the invention enhances tunnelling currents.

Preferably, the optoelectronic material comprising black silicon on a silicon substrate obtained by the method of the invention is used on thinned silicon wafers having a thickness lower than 100 µm.

The inventors also suggest an opto-electronic material comprising:
- a silicon substrate comprising black silicon on top of said silicon substrate, black silicon comprising a plurality of silicon nano-cones with a density comprised between 25 and 500 nano-cones per µm²:
   - each of said silicon nano-cones having a nano-cone base and a nano-cone tip;
   - each of said silicon nano-cones having a nano-cone height delimited by said nano-cone base and said nano-cone tip;
   - said nano-cone base being parallel to said silicon substrate and being delimited along one direction by a first base end and a second base end;
   - each of said silicon nano-cones having a nano-cone width delimited by said first base end and by said second base end;
   - said nano-cone height being comprised between 300 nm and 3000 nm, and;
   - said nano-cone width being comprised between 50 and 200 nm;
- a passivation layer on top of said plurality of silicon nano-cones.

The advantage of the optoelectronic material comprising improved black silicon is that the minority carrier lifetime of the black silicon is above 3 ms.

The optoelectronic material is also an optoelectronic body for applications which are preferably: image sensors, thermal imaging cameras, photodetectors, terahertz applications, solar cells and, antibacterial surfaces.

Preferably, the silicon nano-cones have a surface density comprised between 25 and 500 nano-cones per µm². Black silicon with a nano-cone surface density comprised between 25 and 500 nano-cones per µm² allows optimal optical performances. Said nano-cone surface density allows a very good absorption of incoming light. Nano-cone high surface density and nano-cone high homogeneity over large areas allow a very good absorption of incoming light. Said nano-cone surface density is also a good trade of for having nano-cones with high absorption and high charge carriers lifetimes.

The advantages described for the method for producing improved black silicon on a silicon substrate according to the first aspect of the invention and for the optoelectronic material also apply to the optoelectronic material comprising black silicon on a silicon substrate according to the second aspect, *mutatis mutandis.* The different variants for the method according to the first aspect and to the second aspect of the invention as described in the preceding text also apply to the optoelectronic material according to the invention, *mutatis mutandis.*

The inventors also suggest a photovoltaic device comprising said opto-electronic material.

### Brief description of the figures

These aspects of the invention as well as others will be explained in the detailed description of specified embodiments of the invention, with reference to the drawings in the figures, in which:
Figure 1 shows a sequential view of the different steps needed to obtained black silicon on a silicon substrate by using a mask-free technique.
Figure 2 shows a schematic representation of black silicon describing steps of oxidation, etching and passivation.
Figure 3 shows a schematic representation of black silicon describing the gradient of refractive index of black silicon.
Figure 4 shows three scanning electron microscope pictures taken at different steps of the method of the invention.
Figure 5 shows pictures of a black silicon substrate and of a silicon substrate with a sandglass structure.
Figure 6 shows results obtained by the method of the invention and for the claimed material and state of the art results.
Figure 7 shows reflectance spectra of silicon, silicon sandglass structure and black silicon.

### Detailed description of possible embodiments of the invention

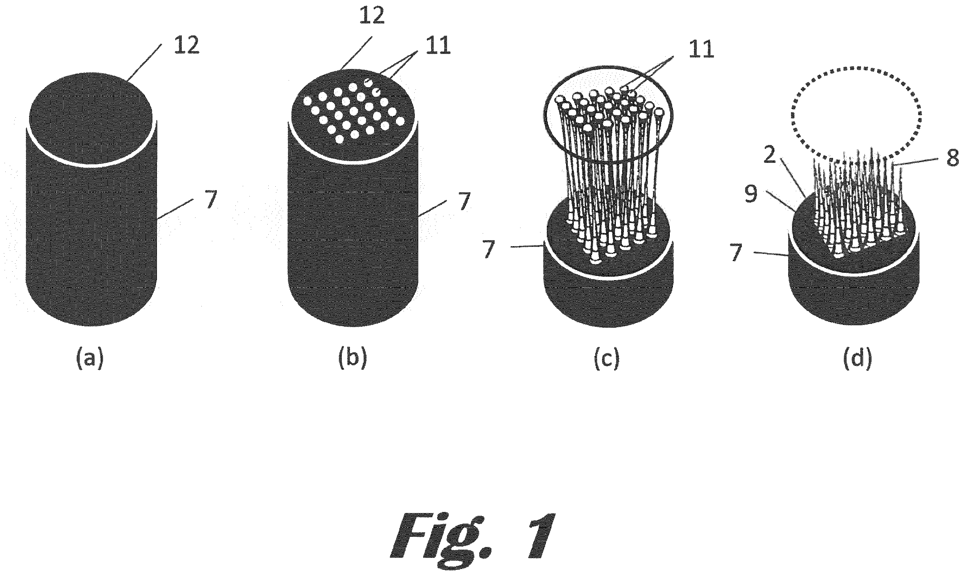

Figure 1 shows five schematic views of the different steps used to obtain black silicon starting from a silicon substrate. Figure 1 (a) shows a silicon substrate 7 having a top surface 12. Figure 1(b) shows a silicon substrate 7 with aluminium oxide particles on its top surface 12. Figure 1(c) shows a silicon substrate 7 with a sandglass structure. The sandglass structure is a nano-structure made of silicon filament type at the top surface of a silicon substrate. Each filament having on its top a remaining of the aluminium oxide particle or of silicon oxide. Figure 1(d) shows black silicon 1 on a silicon substrate 7. Black silicon 1 being a high aspect-ratio antireflective structure on a silicone substrate 7. Black silicon 1 can be described as many silicon needles or nano-cones 2 on top of a silicon substrate 7.

The step to go from figure 1(a) to figure 1(b) comprises sub steps. In order to scatter aluminium oxide nanoparticles on the silicon substrate 7 top surface 12, a voluntary dispersion of nanoparticles in the chamber for the etching of said silicon substrate top surface 12 into black silicon 1 is needed. Before bringing the silicon substrate 7 into the chamber for etching the silicon substrate and get to figure 1(c), a substrate coated with an aluminium oxide layer is loaded in said chamber. For example, the aluminium oxide layer has a thickness comprised between 10 nm and 500 nm. The aluminium oxide coated wafer can be utilized for several runs of black silicon 1 fabrication. The aluminium oxide layer 10 is preferably deposited by an atomic layer deposition technique. The aluminium oxide layer 10 is for example deposited by a sputtering deposition technique. The aluminium oxide layer 10 is for example deposited by a chemical vapor deposition technique. The aluminium oxide layer 10 is for example deposited by a chemical vapor deposition technique with a thermal mode.

After bringing the aluminium oxide coated wafer into said chamber, a plasma etching of the aluminium oxide coated wafer is applied. Plasma etching of the aluminium oxide coated wafer is preferably performed with using CCl₄ as the etching gas. The plasma with CCl₄ is for example applied to the aluminium oxide coated wafer for 5 minutes. Plasma etching with an etching gas is also referred to as reactive ion etching. Reactive ion etching of the aluminium oxide coated wafer allows to remove partially the aluminium oxide coating of the wafer and to leave out fragments of aluminium oxide. The fragments of aluminium oxide can be called aluminium oxide nanoparticles, or aluminium oxide dusts, or even aluminium oxide particles. The chamber left out with aluminium oxide nanoparticles is also said to be loaded with aluminium oxide nanoparticles. For example, nanoparticles are plasma by-product nanoparticles. The nanoparticles are for example deposited on the walls or any other parts of the plasma chamber. Preferably, loading said chamber with aluminium oxide nanoparticles one time allows for several runs of etching a silicon substrate 7 top surface 12 to obtain black silicon 1. One run of etching the silicon substrate 7 with Cl₂/O₂ plasma does not consume all the aluminium oxide nanoparticles that are in the plasma chamber. For example, loading of the plasma chamber with aluminium oxide nanoparticles is necessary every five runs of etching with Cl₂/O₂. For example the nanoparticles are provided in a recipient that is placed inside the plasma chamber and that do not require to do a CCl₄ etch of an aluminium oxide coated wafer.

After aluminium oxide nanoparticles have been produced within the chamber, the aluminium oxide coated wafer is taken out of said chamber. Produced aluminium oxide nanoparticles are left inside the chamber. The chamber is not cleaned nor the produced aluminium oxide nanoparticles are removed from said chamber. Subsequently, the silicon substrate 7 with a top surface 12 is brought into the chamber. The chamber with the loaded silicon substrate 7 having a top surface 12 is then closed and a vacuum can be created in the chamber. During the operation of loading the silicon substrate 7 into the chamber, previously produced aluminium oxide nanoparticles scatters over the top surface 12 of said silicon substrate 7.

The aluminium oxide nanoparticles are preferably randomly distributed over the top surface 12 of the silicon substrate 7. The aluminium oxide nanoparticles have for example rounded shapes. The aluminium oxide nanoparticles are preferably homogeneously distributed over the top surface 12 of a silicon substrate 7. For example the size and the diameter of the aluminium oxide nanoparticles are nearly identical all over the top surface 12 of a silicon substrate 7. The etching parameters of the CCl₄ plasma used for producing the aluminium oxide nanoparticles allow for example to tune the size and the shape of the aluminium oxide nanoparticles. Dispersed aluminium oxide nanoparticles on the silicon substrate 7 top surface 12 can also be viewed as an aluminium oxide nano-mask 11. The scattered or dispersed aluminium oxide nanoparticles at the top surface 12 of a silicon wafer 7 allow to mask parts of the silicon substrate 7 top surface 12 during etching.

The aluminium oxide nanoparticles that are present in the plasma chamber when entering the silicon substrate 7 with a top surface 12 are directed to and dispersed on said top surface 12 when switching on the electric field for the plasma. The electric field for generating the plasma is created between the silicon substrate 7 and a grid within the plasma chamber. For example the applied electric field charges the silicon substrate 7 and then aluminium oxide nanoparticles are attracted on top of said top surface. The nanoparticles are attracted on the top surface 12 in such a way that they are dispersed on said top surface 12. The nanoparticles are attracted on the top surface 12 in such a way that they are randomly dispersed on said top surface 12. For example the nanoparticles are deposited on the top surface 12 of the silicon substrate 7 during the phase of pumping down the plasma chamber or during the phases of introducing a gas into the plasma chamber. Both pumping down and introducing a gas into the chamber create an air flux and deposit the nanoparticles that are for example on the walls of the chamber onto the silicon substrate 7 top surface 12. For example the deposition of the nanoparticles on the top surface 12 of the silicon substrate 7 combines the application of an electric field and the air flux within the plasma chamber.

Another example of nano-mask 11 deposition on the silicon substrate 7 top surface 12 is for example to use a solution containing nanoparticles and to spray it or spin coat it on said top surface before putting the silicon substrate 7 into the plasma chamber. The advantage of depositing the nano-mask 11 nanoparticles in such a way allows to keep the plasma chamber relatively clean and to have a better control about the composition and size of the nanoparticles.

The aluminium oxide nanoparticles form a nano-mask 11 because the nanoparticles are preferentially dispersed individually or with small aggregates on the top surface 12. The individual nanoparticles or aggregates preferably cover a surface of the top surface 12 of the silicon substrate 7 that is comprised between 0.001 and 0.01 µm². For example a nanoparticle has a maximum dimension of 100 nm.

The step to go from figure 1(b) to figure 1(c) is an etching step of the silicon substrate 7. This step utilises the aluminium oxide nanoparticles nano-mask 11 created during the previously described steps. Etching of the silicon substrate 7 preferably involves pre-etching of the top surface 12 of the silicon substrate 7 with a plasma using CCl₄ as the etching gas. Pre-etching allow for example to remove the native oxide of the top surface 12 of the silicon substrate 7 in order to allow a more homogeneous etching.

Etching is done from the top surface 12 of the silicon substrate 7. To form the plasma for etching the silicon substrate 7, an electric potential is applied between a grid preferably placed above the silicon substrate 7 and the silicon substrate 7 or a grid placed under the silicon substrate 7. The electric field allows the ionization of the plasma gas and to direct the ionized species to the silicon substrate 7 top surface 12. The plasma allows to etch the silicon substrate 7 from its top surface 12 thanks to the ionized species that are directed perpendicular to the top surface 12. The advantage of using a plasma technique for etching the areas that are not covered by the aluminium oxide nano-mask 11 is that the plasma etches from top to bottom with very limited etching underneath the mask. Etching with a plasma allows to etch high depth starting from a top surface, etched depths being perpendicular to the top surface. Plasma etching allows to keep in place the silicon which is covered by a mask perpendicularly to the top surface 12. With a plasma technique, depths up to 3000 nm can be achieved.

For example, the Cl₂/O₂ plasma produces chlorine ions or radical that react with silicon atoms of the silicon substrate 7 to form silicon chloride compounds that are volatile. For example, the plasma also produces oxygen ions or radicals that react with silicon atoms of the silicon substrate 7 to form silicon oxide. The silicon oxide is preferably formed at areas surrounding the aluminium oxide nanoparticle nano-mask 11. The silicon chloride compounds are preferably formed at areas located around aluminium oxide nanoparticles nano-mask 11. Formation of silicon chlorine compounds that are evaporated allows to remove parts of the silicon substrate 7 from the top surface 12. Plasma of Cl₂/O₂ allows to etch silicon substrate 7. The plasma needs a well-defined degree of anisotropy to produce nano-cones with sharp shapes.

The step to go from figure 1(b) to figure 1(c) comprises etching of the silicon through the aluminium oxide nano-mask 11 with a plasma using Cl₂ and O₂ as etching gases. The plasma using Cl₂ and O₂ as etching gases is preferably applied in said chamber at a pressure comprised between 1 and 20 Pa (10 to 150 mTorr), more preferably, the plasma chamber is at a pressure of 6,7 Pa (50 mTorr). This plasma etching allows to etch the silicon selectively around and under the aluminium oxide nano-mask 11. The plasma is preferably applied between 2 and 30 minutes, more preferably between 5 and 20 minutes and still more preferably in the range of 7 to 12 minutes. This plasma allows etching of the silicon around and under the aluminium oxide nano-mask 11 with a depth varying from dozens of nanometres to few micrometres. The etching depth depends on the plasma application time for a given plasma chamber pressure, plasma power, and etching gas concentration and composition. The etching depth for identical conditions may also vary function of the interval between the aluminium oxide nano-mask 11. The control of the vertical etching rate and the control of the lateral etching rate are important to be achieved with a good ratio in order to obtain optimal black silicon. After etching of the silicon by a Cl₂/O₂ plasma, a sand glass structure is obtained at the surface of a silicon substrate 7. The sandglass structure is characterized by silicon pillars or rods connected to the silicon substrate 7 and having on top of the plurality of pillars or rods, left overs of the aluminium oxide nano-mask 11 and silicon oxide. Silicon pillars or rods can also be seen as double-cones having their tips coinciding. Preferably, the silicon top of the sandglass structure become SiO₂ during the etching because of the O₂ in the plasma. For example, one silicon pillar is obtained for one aluminium oxide nanoparticle. The obtained silicon pillars preferably have a section that is larger at its bottom and at its top and has a thinner section at its middle height. The obtained silicon pillars have a shape of a sandglass. The obtained pillars have preferably a similar height all over the silicon substrate 7 etched area. Preferably, the silicon substrate 7 with a sandglass structure on its top surface does not yet exhibit black silicon anti-reflective (AR) properties and or absorption properties. An example reflection spectrum of a silicon substrate 7 having a sandglass surface structure has a reflexion comprised between 1% and 4 % in the range 300 nm to 750 nm.

The step to go from figure 1(c) to figure 1(d) comprises several chemical wet etching and cleaning sub-steps in order to remove a top part of the sandglass structure to form black silicon 1. Preferably, the sandglass structure is immersed in a piranha solution, for example containing a mixture of H₂SO₄ and H₂O₂. Immersing the sandglass structure into said solution aims at removing parts of the aluminium oxide nano-mask 11 lefts overs and parts of formed silicon oxide. Immersing the sandglass structure into a solution containing a strong acid allow to remove any metal or metal oxide and most organic compounds at the surface of the silicon substrate surface. After chemically removing the remaining aluminium oxide parts or the plasma-by product of the sand glass structure, the silicon substrate 7 is preferably immersed in a deionized water bath in order to rinse out the solution containing H2SO4 and H2O2. The silicon substrate 7 is then immersed in a bath containing hydrofluoric (HF) acid. The silicon substrate 7 is immersed in HF acid in order to etch away the top part of the silicon pillar in order that only the silicon nano-cones 2 remain on the silicon substrate 7. For example, half of the height of the silicon pillars are etched, including the silicon oxide at the top of said pillars. After etching in HF, the silicon substrate 7 is rinsed in deionized water in order to stop the etching of the silicon. The silicon substrate 7 is then further rinsed and dried.

The created silicon nano-cones 2 on the silicon substrate 7 are also called black silicon 1. The black silicon 1 is a silicon substrate 7 having a high aspect ratio on its top surface. The high aspect ratio preferably has a conical pyramidal, columnar or needle like shape pattern. The high aspect ratio of the silicon substrate 7 top surface 12 allows a very low reflectance, lower than 1% in the visible/near IR range, and subsequently allowing more light to be absorbed in the silicon substrate. The high aspect ratio of the silicon substrate 7 top surface 12 allows a very high light absorption, close to 1, and thus a very low reflectivity, lower than 1 % in the visible and infrared light range. The created silicon nano-cones 2 preferably have a height 14 comprised between 100 nm and 10 µm and more preferably a height 14 comprised between 300 nm and 3 µm. Said silicon nano-cones 2 preferably resemble a cone having a circular base 9. The distance 13 between the centre of two silicon nano-cones 2 is preferably comprised between 50 nm and 190 nm, more preferably comprised between 55 nm and 180 nm and even more preferably comprised between 60 nm and 150 nm. Considering the formed nano-cones 2 have a circular base, they preferably have a diameter comprised between 50 nm and 200 nm. Preferably the nano-cones 2 are adjacent to each other's, that is to say that there is no or almost no silicon section not being part of a silicon nano-cone 2 between each of the silicon nano-cones 2. Preferably the black silicon 1 nano-cones 2 have a surface density comprised between 25 and 500 nano-cones per µm². Preferably the silicon nano-cones 2 are perpendicular to the silicon substrate 7. For example, the silicon nano-cone 2 base is connected to the silicon substrate 7 and the silicon nano-cone tip 8 is the part of the nano-cone 2 which is the furthest from the silicon substrate 7.

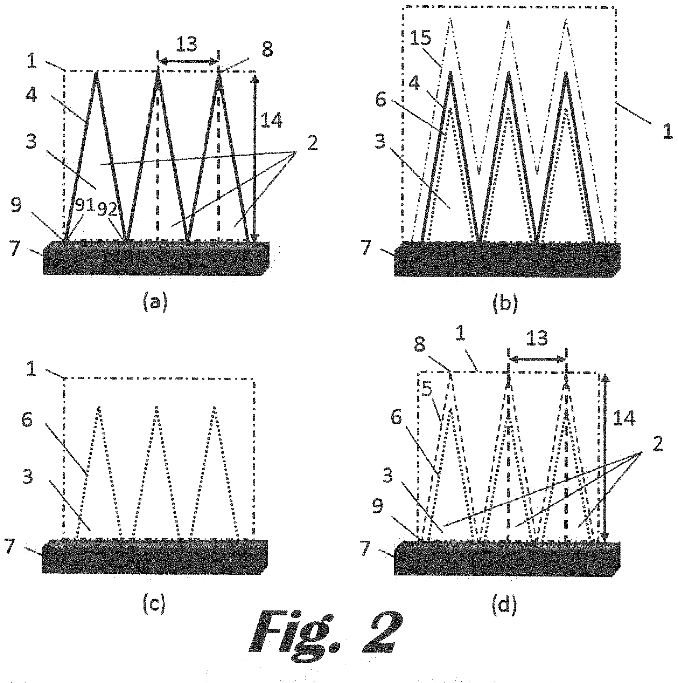

Figure 2 shows schematic representations of the cross-section of three aligned silicon nano-cones 2. Figure 2(a) shows black silicon 1 which comprises silicon nano-cones 2 on a silicon substrate 7. Figure 2(a) represents the same black silicon 1 that is represented on figure 1(e). The silicon nano-cones 2 have a height 14 taken from the base 9 of a silicon nano-cone 2 and the tip 8 of a silicon nano-cone 2. The silicon nano-cones 2 have a nano-cone bulk 3. The silicon nano-cone bulk 3 is preferably a silicon monocrystal which is part of silicon substrate 7 monocrystal. The silicon nano-cone 2 bulk 3 has a silicon nano-cone surface 4. The silicon nano-cone 2 surface is represented by the solid line.

Figure 2(b) shows black silicon 2 on top of which a silicon oxide layer 15 has grown up. The silicon oxide layer 15 covers the entire silicon nano-cones 2 surface 4. The silicon oxide layer 15 is represented by a long dash dot dot line. The dotted line represents the boundary between the silicon nano-cone 2 bulk 3 and the silicon oxide grown layer 15. As the growth of the silicon oxide layer 15 consumes silicon, the boundary 6 between the silicon oxide layer 15 and the silicon bulk 3 is situated underneath the original silicon nano-cone 2 surface 4. The boundary 6 between the grown silicon oxide layer 15 and the silicon bulk 3 is represented by a dotted line.

Figure 2(c) shows black silicon 1 after the silicon oxide layer 15 has been etched away. The silicon nano-cones 2 are represented by the dotted lines. A layer of the silicon nano-cones 2 is removed by subsequently growing silicon oxide and removing it. The removed layer is intended to be a silicon oxide layer 15 with a substantial number of defects and traps. This removed layer is thought to contain many traps and defects because it was exposed to several steps comprising reactive ion etching and wet etching. These physical and chemical treatments which allow to achieve the desired surface topology of the silicon substrate also causes some damages to the silicon nano-cones 2 and preferably at the silicon nano-cone surface. Defects and traps in the silicon nano-cone can be due for example to dangling bonds and silicon vacancies within the silicon nano-cone bulk and or diffusion of atomic species such as Cl, O, C, F, H or any other impurities introduced during the reactive ion etching treatments with etching gases Cl₂, O₂, CCl₄ and also for example during the wet etching treatment. The number of defects or traps at the surface of a silicon nano-cone 2 preferably varies with the height 14 of the nano-cone 2, the surface 4 of a silicon nano-cone 2 and for example its aspect ratio. The grown thickness of silicon oxide 15 can be adapted to the defect concentration and depth from the silicon nano-cone 2 surface 4. This technique allows to further smooth the plurality of silicon nano-cones 2 and to reduce their defect and trap density at their surfaces.

Figure 2(d) shows black silicon 1 after deposition of a passivation layer 5. The passivation layer 5 is represented by the dashed lines parallel to the dotted lines. The thickness of the passivation layer 5 is preferably comprised between 1 and 100 nm, more preferably between 15 and 30 nm and is preferably of 15 nm. The passivation layer 5 preferably completely covers the silicon nano-cone 2 surface 4. The passivation layer 5 preferably completely covers the boundary 6 between the just removed silicon oxide layer 15 and the silicon nano-cone 2 bulk 3.The passivation layer 5 preferably covers entirely the black silicon 1 surface. The aim of the passivation layer 5 is preferably to reduce the not desired recombination at the silicon nano-cone 2 surface.

The step to go from Figure 2(a) to Figure 2(b) comprises growing of a silicon oxide layer 15 at the surface of the black silicon 1 nano-cones 2. Growing of a silicon oxide layer 15 is preferably achieved by thermal oxidation in an oxygen rich atmosphere. The growth of said silicon oxide layer 15 is for example an oxidation of the silicon nano-cone 2 surface 4. The oxidation of the black silicon 1 nano-cones 2 is preferably done at a temperature comprised between 800 °C and 1100 °C and more preferably done at 950 °C for a duration preferably comprised between 10 minutes and 30 minutes and more preferably for 15 minutes. The oxidation is preferably done in an oxygen rich atmosphere. The thickness of the silicon oxide layer 15 on the black silicon 1 nano-cones 2 can be controlled by varying the temperature, duration and O₂ concentration of the oxidation process.

The step to go from Figure 2(b) to Figure 2(c) comprises the etching of the silicon oxide layer 15 formed during the previous oxidation step. Etching of the silicon oxide layer 15 is intended to remove silicon oxide formed at the black silicon 1 nano-cone 2 surface 4. It preferably allows to leave the black silicon 1 nano-cones 2 surface 4 without silicon oxide. For example, it is acceptable to leave the black silicon 1 nano-cones 2 surface 4 with few nanometers of silicon oxide. The etching of silicon oxide layer 15 is preferably performed by immersing the black silicon 1 nano-cones 2 in a HF acid bath. The immersion time of the black silicon 1 nano-cones 2 in the HF acid bath depends on the silicon oxide layer 15 thickness to be removed and to the concentration of HF acid and to the bath temperature. After immersion of the black silicon 1 nano-cones 2 in the HF acid bath, the black silicon 1 nano-cones 2 are rinsed preferably with deionized water. The black silicon 1 nano-cones 2 are then preferably further rinsed and dried. The reflectance of the black silicon 1 is preferably not changed by the oxide layer 15 growth and by its subsequent etching. The reflectance measured with the black silicon 1 presented in Figure 2(a) is for example in the same range than the reflectance measured with the black silicon 1 presented in Figure 2(c).

The step to go from Figure 2(c) to Figure 2(d) comprises the deposition of a passivation layer 5. The passivation layer 5 is preferably a metal oxide layer. The passivation layer 5 is preferably deposited by a chemical vapor deposition (CVD) technique. The passivation layer 5 is more preferably deposited by atomic layer deposition (ALD), preferably at a temperature of 250 °C. The passivation layer 5 is for example deposited by a physical deposition technique, for example by a sputtering technique. The deposited passivation layer 5 is preferably an aluminium oxide passivation layer 5. The passivation layer 5 is then preferably annealed after its deposition on the black silicon nano-cones 2. The passivation layer 5 is for example annealing in a forming gas. Forming gas can contain N₂, O₂, H₂, and other gases. A forming gas preferred composition is composed of 95% of N₂ and 5% of H₂. For example, the forming gas has any other composition. The passivation layer 5 is preferably annealed in a forming gas for about 30 minutes. The passivation layer 5 is preferably annealed in a forming gas, preferably at a temperature comprised between 380 °C and 480 °C and more preferably done at 430 °C. The annealing of the passivation layer 5 preferably allows to activate the passivation layer 5.

The density of the nano-cones 2 at the surface of the silicon substrate 7 is high because there is preferably no gap between each nano-cone 2. For example a cross-section perpendicular to the silicone substrate 7, gives a saw tooth profile because there is none or almost no gap between each nano-cone 2. Furthermore, the method describes the removal of a surface layer 4 having a thickness up to 50 nm. Preferably the thickness of the removed surface layer 4 is of about 10 nm, meaning that after removal of such layer, there may be a gap of about 10 nm. After deposition of the passivation layer 5 having a thickness of a few nanometer, the gap between each cone is therefore very limited. Because of these reasons, the density of the silicon nano-cones 2 is high and the nano-cones 2 have a good repetition rate at the surface of the silicon substrate 7.

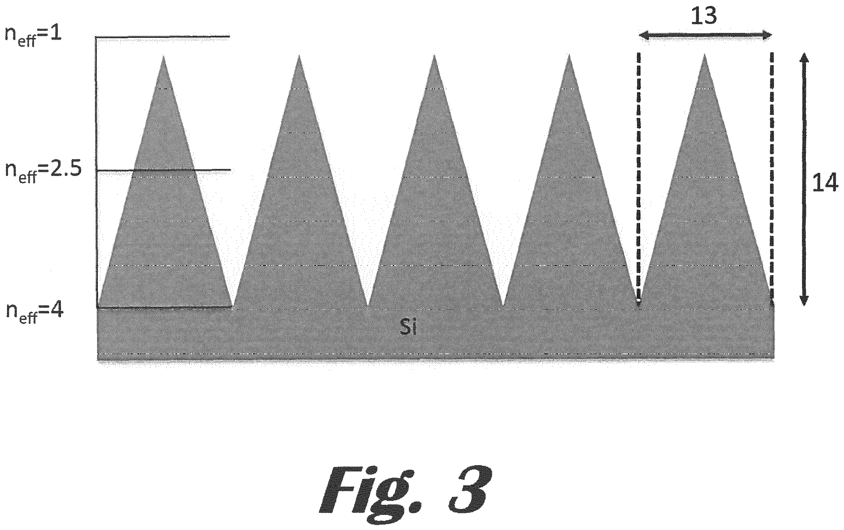

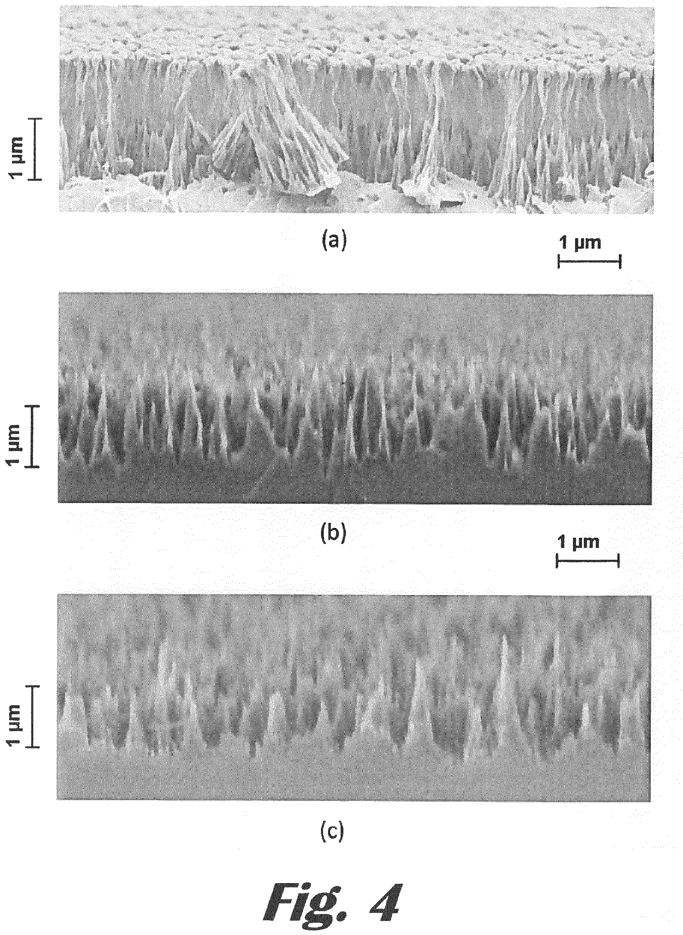

Figure 3 shows a schematic representation of the cross-section of black silicon 1 nano-cones 2. The nano-cone 2 interval or the width of the nano-cone base 9 is represented by 13. The nano-cone 2 width 13 is delimited by a first base end 91 and by a second base end 92. The first base end 91 and second base end 92 can be defined by taking the two intersections of two lines drawn along the nano-cone 2 at its opposite sides and a line representing a silicon substrate 7 surface around the nano-cone 2. The distance 13 between the centre of two silicon nano-cones 2 or the distance between two silicon nano-cones 2 first base end 91 (or second base end 92) is preferably comprised between 50 nm and 200 nm, more preferably comprised between 55 nm and 180 nm and even more preferably comprised between 60 nm and 150 nm. The height 14 of the nano-cone 2 is also shown. In reality the nano-cone base width 13 and the nano-cone 2 height show variations as it can be seen on Figures 4(b) and Figure 4(c). On the left of figure 3 is shown a scale giving approximate refractive indexes. The effective refractive index of the air being close to 1 and the effective refractive index of bulk silicon being approximately 4 in the visible light range. The light sees the black silicon 1 structure as a multilayer with gradually increasing optical index. The interest of black silicon 1 because it exhibits a large range of refractive indexes at its surface, is that it can absorb light with various wavelengths and angle of incidence in a very efficient way. Black silicon 1 nano-cones 2 are multifaceted type of nano-cones 2 to capture light with different angles. Thanks to this graded refractive index shape, light with various angle of incidence can find a black silicon 1 portion that allow a good absorption. The graded optical index also reduces the reflection for a large range of incident angles, as long as the dimensions of the black silicon 1 structure are smaller than the wavelength. This structure also allows to absorb light that would first be reflected by the black silicon 1 nano-cones 2. This structure also offers to each wavelength a preferred refractive index portion for efficient light absorption.

The black silicon 1 obtained as explained by the method of the invention offers a graded refractive index structure allowing for efficient light absorption for a large range of wavelengths and of incidence angles. The fact that the black silicon 1 nano-cones 2 do not all have the same height 14 and width 13 means that the gradient of refractive index varies for each individual nano-cone 2. The gradient of refractive index of each black silicon 1 nano-cone 2 is unique for each black silicon 1 nano-cone 2. The black silicon 1 obtained offers a gradual matching of the refractive index for the incident light.

Figure 4 shows three scanning electron microscope cross-sections pictures of a silicon substrate 7 with different silicon structures on its top surface. Figure 4(a) shows a silicon substrate 7 with a sandglass structure on its top surface. Figure 4(b) shows a silicon substrate 7 with black silicon 1 nano-cones 2 on its top surface. Figure 4(c) shows a silicon substrate 7 with black silicon 1 nano-cones 2 on its top surface covered by an Al₂O₃ passivation layer 5. The sandglass structure shown in the Figure 4(a) is the structure described in figure 1(d). The black silicon 1 nano-cone 2 structure shown in figure 4(b) is the structure described in Figure 1(e) and Figure 2(a). The black silicon 1 nano-cones 2 structure shown in the Figure 4(c) is the structure described in Figure 2(d).

Figures 4(b) and 4(c) exhibit a very similar black silicon 1 surface structure with nano-cones 2 of approximately the same width 13 and height 14. The difference between these two figures is that the black silicon 1 nano-cones 2 of Figure 4(c) have been submitted to the steps of oxidation, etching and passivation described to go from Figure 2(a) to Figure 2(d). The black silicon 1 nano-cones 2 obtained after passivation in Figure 4(b) have for example a smoother surface than the black silicon 1 nano-cones 2 described in Figure 4(c). The absorption spectrum of the black silicon 1 shown in Figure 4(b) preferably has the same absorption spectrum than the passivated black silicon 1 shown in Figure 4(c). The reflectance is even lower in the case of the passivated black silicon 1. The black silicon 1 after passivation preferably allows less surface recombination when the black silicon 1 is used for example in a photovoltaic device. The black silicon 1 after passivation preferably has a minority carrier lifetime above 3 ms.

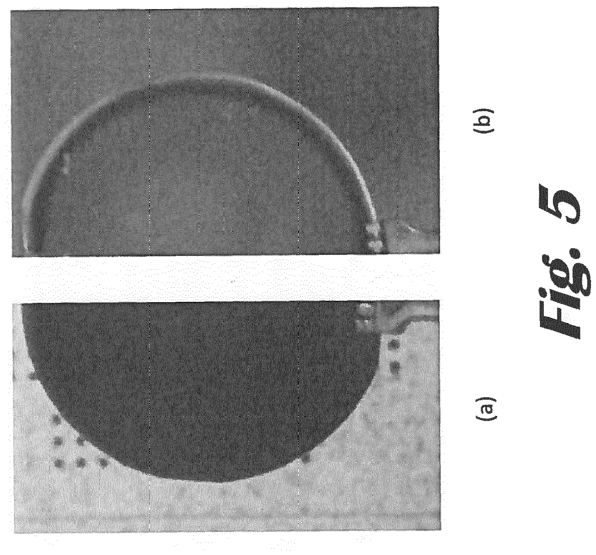

Figure 5 (a) shows a silicon substrate 7 processed according to the invention, said silicon substrate 7 is a black silicon 1 substrate. The silicon substrate 7 appears black, not blackish nor dark grey. Figure 5 (b) shows a silicon substrate 7 not processed according to the invention. Preferably the silicon substrate 7 of Figure 5 (b) is obtained before subjecting said substrate to a chemical composition, the structure obtained is typically a sandglass structure as also represented on Figure 1(c) and on Figure 4(a).

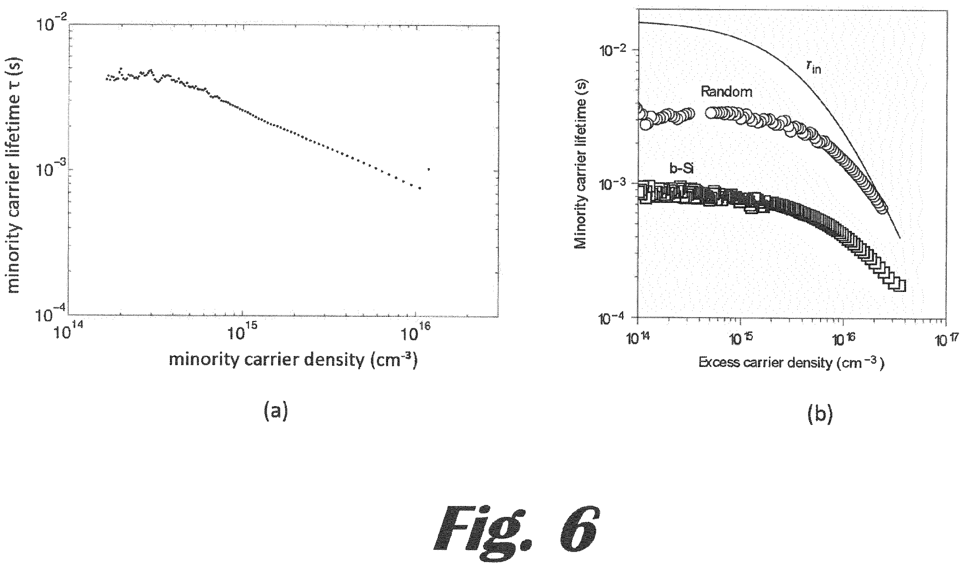

Figure 6(a) shows a typical characteristic of the black silicon 1 obtained by the method of the invention. This result is presented as a graph with the minority carrier lifetime expressed in seconds on the Y axis and with the minority carrier density with cm⁻³ as a unit on the X. Figure 6(b) shows a state of the art plot with comparable axis values and data showing in squares the results obtained for state of the art black silicon. Comparing the state of the art results and the results obtained by the method of the invention, it appears that black silicon obtained by the method of the invention provides better minority carrier lifetimes for any minority carrier density comprised between 10¹⁴ and 10¹⁶ cm⁻³.

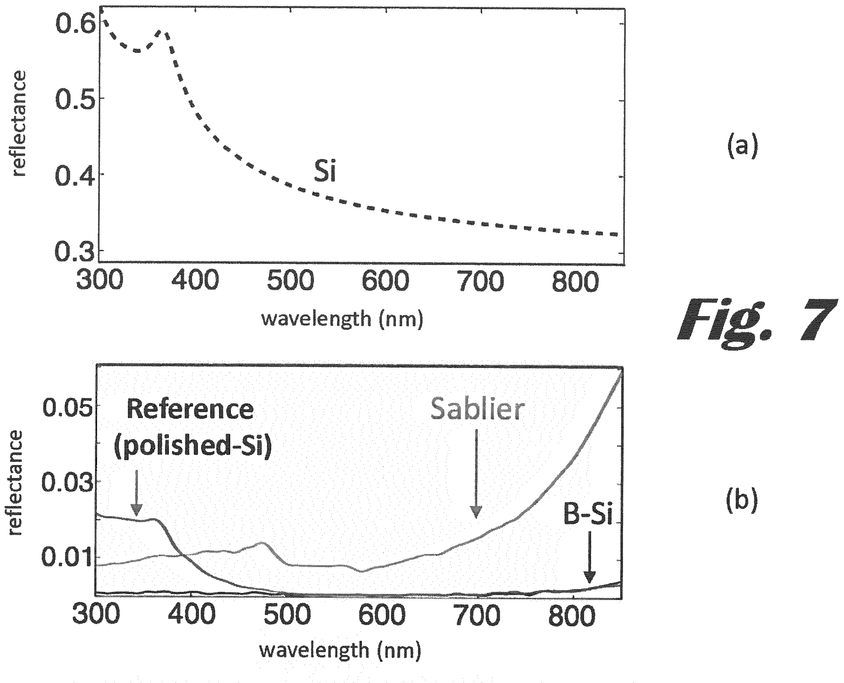

Figure 7(a) shows a reflectance spectrum of a single crystal polished silicon substrate 7 or of the silicon substrate 7 before the method of the invention. Figure 7(b) shows a reflectance spectrum of a silicon substrate 7 with a sandglass structure, this spectrum shows a reflectance of about 0.06 at a wavelength of 850 nm. Figure 7(b) also shows a reflectance spectrum of the black silicon 1 obtained by the method of the invention, this spectrum shows reflectance values below 0.01 over the range of wavelength 300 to 850 nm.

### A first preferred example of the method of the invention comprises the following steps:

A wafer coated with an aluminium oxide layer is introduced into the plasma chamber. A CCl₄ plasma is applied on the aluminium oxide layer for producing aluminium oxide dust in the plasma chamber. A typical plasma exposition time of the aluminium oxide coated wafer is comprised between 30 seconds and 300 seconds, at a chamber pressure comprised between 50 mTorr and 70 mTorr, with a plasma power comprised between 40 W and 60 W. This step allows for removing partially the aluminium oxide coated layer 10 and to leave out dusts in the plasma chamber. A silicon substrate 7 is chosen, for example a Float Zone Silicone wafer p-type having a high purity, with a resistivity preferably comprised between 1-10 Ohm.cm. Preferably, the silicon substrate 7 is cleaned following a standard cleaning step. Said standard cleaning step preferably comprises the following steps in the following order:
- immersion for approximately 10 minutes in a solution containing H₂SO₄ and H₂O₂;
- rinsing for approximately 10 minutes with DI water;
- immersion for approximately 30 seconds in a 2% HF solution;
- rinsing for approximately 10 minutes with DI water;
- rinsing and or drying for approximately 12 minutes;
Then a cleaned silicon substrate 7 is preferably loaded in a plasma chamber containing aluminium oxide nanoparticles or dusts. The nanoparticles of aluminium oxide are dispersed over the silicon substrate 7 top surface 12 to serve as nano-mask 11. This is a dust assisted or nanoparticle assisted masking technique which allows to directly create a mask on a silicon substrate 7 top surface 12.
Creation of the black silicon 1: After deposition of the aluminium oxide nano-mask 11 at the silicon substrate 7 surface 12, a pre-etching step is optionally applied in order to remove the native oxide on the silicon substrate 7 and for pre-etching of the silicon substrate 7 surface 12. A typical plasma exposition time for the optional pre-etching step is comprised between 30 seconds and 120 seconds, at a chamber pressure comprised between 50 mTorr and 70 mTorr, with a plasma power comprised between 40 W and 60 W. The silicon substrate 7 with aluminium oxide nano-mask 11 is then etch with a Cl₂/O₂ plasma during 7 minutes. This step allow to etch the silicon around and under the aluminium oxide nano-mask 11.
After etching of the silicon substrate 7 around and under the aluminium oxide nano-mask 11, multiple steps for cleaning, wet etching and smoothing are applied to the silicon substrate 7. The silicon substrate 7 with an etched surface is then processed as follow:
- 10 minutes in H2SO4/H2O2;
- 10 minutes in DI water;
- 1 min in HF 2%;
- 10 minutes in DI water;
- 12 minutes in a rincer / dryer.
Black silicon 1 is obtained after the cleaning, wet etching and smoothing steps. Black silicon 1 is a nanostructured surface of the silicon substrate 7.
A dry oxidation of the black silicon 1 is then performed in order to obtain a silicon oxide 15 thickness comprised between 7 to 12 nm. The dry oxidation of the black silicon 1 is carried out at 950°C with O₂ for 15 minutes.
After the growth of a silicon oxide layer 15 at the surface of the black silicon 1, the just grown silicon oxide layer 15 is removed and the black silicon 1 is smoothed with the following steps:
- Etching the SiO2 with HF 2%
- 10 min in DI water
- 12 min rinser dryer
After removing the silicon oxide layer 15 and further smoothing of the black silicon 1, a passivation layer 5 is deposited at the top surface of the black silicon 1. The passivation layer 5 is an aluminium oxide layer deposited by thermal atomic layer deposition (t-ALD) with a temperature chamber of 250°C.
In order to activate the passivation layer 5, the silicon substrate 7 with passivated black silicon 1 on its top surface is annealed for 30 minutes in a forming gas having the following composition: 95% N₂, 5% H₂.

### A second example of the plasma parameters used during the method of the invention:

Parameters ; CCl₄ ; Cl₂/O₂
Composition [sccm] ; 18 ; 16/3
Pressure [mTorr]; 60; 50
Power [W]; 60; 40
Time [s]; 30; 420.

### Plasma system:

Low frequency plasma system with a specific RF-frequency: 187.5 KHz (A common RF-frequency used in prior art is for example: 13.56 MHz).
This is an asymmetrical parallel-plate geometry. The RF power is dispatched on a 3-inch holder (plasma mode, but it also works in RIE mode) and is set to 40 W.
Etching gas: CCl₄ and Cl₂/O₂
Etching time: typically between 7-12 minutes, depending on the size of aluminum oxide mask 11 or of the silicon etching depth desired.

### A preferred example of the passivation layer effect on black silicon p-type silicon nano-cones:

The passivation layer 5 which covers the silicon nano-cones 2 aims at covering entirely the silicon nano-cones 2 surface. The advantage of using t-ALD is that it allows the formation of uniform and conform films over large areas with growth control at the atomic level. The advantage of using thermal ALD over plasma assisted ALD (PE-ALD) is that it allows for a more conform coating of film with, for example, less shadowing effects. Furthermore t-ALD allows to passivate deeps between nano-cones 2, deep trenches or even pores in silicon. An exemplary t-ALD passivation layer of aluminium oxide contains a negative fixed charge density. Black silicon 1 made of silicon nano-cones 2 contains at the silicon nano-cone 2 surface a positive fixed charge density. For example the negative charge density within the aluminium oxide layer induces an accumulation layer at the p-type silicon nano-cone 2 surface when the positive fixed charge within the silicon nano-cone 2 surface is lower than in the aluminium oxide passivation layer 5. Inducing an accumulation layer at the silicon nano-cone 2 surface with an aluminium oxide passivation layer provides a very effective field-effect passivation and drastically reduces the recombination at the silicon nano-cone 2 surface. The passivation layer 5 is able to recover positively charged defects or traps in the silicon nano-cones 2, thanks to the negative net charge of the passivation layer 5, said passivation layer being preferably aluminium oxide.

The present invention has been described with reference to a specific embodiments, the purpose of which is purely illustrative, and they are not to be considered limiting in any way. In general, the present invention is not limited to the examples illustrated and/or described in the preceding text. Use of the verbs "comprise", "include", "consist of', or any other variation thereof, including the conjugated forms thereof, shall not be construed in any way to exclude the presence of elements other than those stated. Use of the indefinite article, "a" or "an", or the definite article "the" to introduce an element does not preclude the presence of a plurality of such elements. The reference numbers cited in the claims are not limiting of the scope thereof.

In summary, the invention may also be described as follows.
Method for producing an optoelectronic material comprising improved black silicon 1 on a silicon substrate 7 and comprising:
- providing a nano-mask 11 comprising a plurality of nanoparticles having a composition different from the one of said silicon substrate 7 and having a surface density on a top surface 12 comprised between 50 and 500 nanoparticles per µm²;
- etching the silicon substrate 7 top surface 12 for forming black silicon 1 comprising a plurality of silicon nano-cones 2 having a height comprised between 300 nm and 3000 nm, and a width comprised between 50 and 200 nm;
- growing a silicon oxide layer on black silicon 1 to form a surface layer 4;
- removing said surface layer 4 having a thickness up to 50 nm;
- depositing a passivation layer 5 on said plurality of silicon nano-cones 2.

## Claims

1. Method for producing improved black silicon (1) on a silicon substrate (7) and comprising the following steps :
a. providing a silicon substrate (7) comprising a top surface (12);
b. providing a nano-mask (11) on said top surface (12), said nano-mask (11) comprising a plurality of nanoparticles, said nanoparticles having a composition different from the one of said silicon substrate (7) and having a surface density on said top surface (12) comprised between 25 and 500 nanoparticles per µm²;
c. processing said silicon substrate (7) from said top surface (12) covered by said nano-mask (11) for forming black silicon (1), said black silicon (1) comprising:
- a plurality of silicon nano-cones (2) with a density comprised between 25 and 500 nano-cones (2) per µm², each of said silicon nano-cones (2) having a nano-cone base (9) and a nano-cone tip (8);
- each of said silicon nano-cones (2) having a nano-cone height (14) delimited by said nano-cone base (9) and said nano-cone tip (8);
- said nano-cone base (9) being parallel to said top surface (12) of said silicon substrate (7) and being delimited along one direction by a first base end (91) and a second base end (92);
- each of said silicon nano-cones (2) having a nano-cone width (13) delimited by said first base end (91) and by said second base end (92);
- said nano-cone height (14) being comprised between 300 nm and 3000 nm, and;
- said nano-cone width (13) being comprised between 50 and 200 nm;
d. removing a surface layer (4) of each of said silicon nano-cones (2), said surface layer (4) having a thickness up to 50 nm;
e. depositing a passivation layer (5) on said plurality of silicon nano-cones (2) after previous step.

2. Method according to previous claim comprising an additional step between step c. and step d.:
- growing after step c. an oxide layer (15) on said silicon nano-cone (2) to form said surface layer (4) to be removed in step d..

3. Method according to any of previous claims **characterized in that** said nanoparticles are made in a material resistant to plasma etching.

4. Method according to any of previous claims **characterized in that** said nanoparticles are oxide or metal-oxide nanoparticles.

5. Method according to any of previous claims **characterized in that** step b. comprises the following steps:
- providing a chamber for receiving said silicon substrate (7);
- providing an oxide coated wafer;
- placing said oxide coated wafer into said chamber;
- etching of said oxide coated wafer with a CCl₄ plasma for forming nanoparticles inside said chamber;
- removing said oxide coated wafer from said chamber;
- placing said silicon substrate (7) into said chamber for depositing oxide nanoparticles on a top surface (12) of said silicon substrate (7);
and **in that** step c. comprises the following step:
- c.1. subjecting said silicon substrate (7) to a plasma for etching it from areas of said top surface (12) located around nanoparticles deposited on said silicon substrate (7) top surface (12).

6. Method according to previous claim **characterized in that** step c. comprises the following additional step:
- subjecting said etched silicon substrate (7) to a chemical composition for removing a top part of it, with a height comprised between 10 nm and 2700 nm.

7. Method according to any of the two previous claims **characterized in that** in step c.1. said silicon substrate (7) is etched with a depth comprised between 300 nm and 3000 nm.

8. Method according to any of the four previous claims **characterized in that** a plasma etching technique with a Cl₂/O₂ plasma is used for step c.1..

9. Method according to previous claim **characterized in that** the Cl₂/O₂ plasma is formed with a RF-frequency comprised between 150 KHz and 200 KHz.

10. Method according to any of previous claims **characterized in that** said passivation layer (5) during step e. is an aluminium oxide layer deposited with a chemical vapour deposition technique.

11. Method according to any of previous claims **characterized in that** the passivation layer (5) is annealed in a forming gas.

12. Opto-electronic material comprising:
o a silicon substrate (7) comprising black silicon (1) on top of said silicon substrate (7) obtained by a method according to any one of previous claims.

13. Opto-electronic material comprising:
- a silicon substrate (7) comprising black silicon (1) on top of said silicon substrate (7), black silicon (1) comprising a plurality of silicon nano-cones (2) with a density comprised between 25 and 500 nano-cones (2) per µm²:
• each of said silicon nano-cones (2) having a nano-cone base (9) and a nano-cone tip (8);
• each of said silicon nano-cones (2) having a nano-cone height (14) delimited by said nano-cone base (9) and said nano-cone tip (8);
• said nano-cone base (9) being parallel to said silicon substrate (7) and being delimited along one direction by a first base end (91) and a second base end (92);
• each of said silicon nano-cones (2) having a nano-cone width (13) delimited by said first base end (91) and by said second base end (92);
• said nano-cone height (14) being comprised between 300 nm and 3000 nm, and;
• said nano-cone width (13) being comprised between 50 and 200 nm;
- a passivation layer (5) on top of said plurality of silicon nano-cones (2).

14. Opto-electronic material according to any of the two previous claims **characterized in that** said silicon nano-cones (2) have a surface density comprised between 25 and 500 nano-cones per µm².

15. A photovoltaic device comprising said opto-electronic material according to any of the three previous claims.
